# EUROPEAN PATENT APPLICATION

(11) **EP 2 783 844 A1**
(43) Date of publication of application: **01.10.2014**
(21) Application number: 14161531.0
(22) Date of filing: 25.03.2014
(51) Int. Cl.: B32B 5/22, B32B 7/00, B32B 7/02, B32B 27/00, B32B 27/08, B32B 27/20, B32B 27/32, B32B 1/02, B01D 71/36, B29C 55/00, H04R 31/00

(54) **WATERPROOF VENTILATION STRUCTURE, WATERPROOF VENTILATION MEMBER, AND WATERPROOF AIR-PERMEABLE MEMBRANE**

(30) Priority: 25.03.2013 JP 2013062294
(71) Applicant: NITTO DENKO CORPORATION, Osaka 567 (JP)
(72) Inventor: Furuuchi, Kouji, IBARAKI-SHI, OSAKA, 567-8680 (JP)
(74) Representative: Intès, Didier Gérard André

(57) **Abstract**

A waterproof ventilation structure (100) including: a housing (20) having an interior space (22) and an opening (21) communicating the interior space with an exterior space; and a waterproof air-permeable membrane (11) covering the opening. The waterproof air-permeable membrane is a layered product including a first stretched porous polytetrafluoroethylene (PTFE) membrane (1) containing a filler and a second stretched porous PTFE membrane (2) not containing a filler. The waterproof air-permeable membrane (11) is disposed so that the second stretched porous PTFE membrane (2) is located closer to the interior space (22) than the first stretched porous PTFE membrane (1). A waterproof ventilation structure (100) configured such that a filler is less likely to fall in a housing.

## Description

The present invention relates to a waterproof ventilation structure including a stretched porous polytetrafluoroethylene (PTFE) membrane, and to a waterproof ventilation member and a waterproof air-permeable membrane suitable for obtaining this waterproof ventilation structure.

Most housings for electrical components for vehicles such as lamps, pressure sensors and electronic control units (ECUs), portable electronic devices such as cellular phones, smart phones, notebook computers and digital cameras, and small household electrical appliances such as electric toothbrushes and shavers have openings formed therein to ensure ventilation between the interior and exterior of the housings. Such an opening eliminates a pressure difference between the interior and exterior of a housing caused by a temperature difference therebetween, and further ensures sound transmission between the interior and exterior of the housing when acoustic transducers such as a microphone and a speaker are placed in the housing. Waterproof air-permeable membranes are increasingly used to cover the openings to prevent water from entering the housings. The waterproof air-permeable membranes are typically stretched porous PTFE membranes obtaining by stretching PTFE sheets.

A waterproof ventilation member including a waterproof air-permeable membrane and a fixing member that are integrally preformed to facilitate attachment to an opening is also known. As the fixing member, for example, a double-sided adhesive tape attached to the peripheral portion of the waterproof air-permeable membrane is used. Another example of the fixing member is a resin member having an air passage formed therein. This resin member has a waterproof air-permeable membrane previously fixed thereto to block the air passage therein, so that the waterproof air-permeable membrane covers the opening only by pushing the waterproof ventilation member into the opening. Examples of such waterproof ventilation members are disclosed in JP 2001-143524 A, JP 2004-047425 A, JP 2008-237949 A, and JP 2003-503991 T.

The original color of stretched porous PTFE membranes is white. However, the stretched porous PTFE membranes are sometimes required to be colored for aesthetic and other purposes when they are used in such a manner that a membrane placed over an opening can be seen by users. Stretched porous PTFE membranes are inherently insulating. However, for example, in order to prevent electromagnetic waves from propagating into housings, the stretched porous PTFE membranes are sometimes required to have electrical conductivity. Therefore, a filler is sometimes added to a stretched porous PTFE membrane depending on the properties required. A typical example of the filler is carbon black, which is added to color the membrane and/or to impart electrical conductivity thereto. A colored stretched porous PTFE membrane is disclosed in, for example, in paragraph 0029 of JP 2003-503991 T.

Stretched porous PTFE membranes have a distinctive microporous structure of nodes and fibrils, and this microporous structure has a finer internal structure than that of commonly available air-permeable materials such as nonwoven fabrics. Therefore, the stretched porous PTFE membranes are superior in holding fillers. However, it has been found that a filler may be dropped off from the stretched porous PTFE membrane by vibration applied to electrical components of a vehicle during a long period of use of the vehicle or by impact applied to a portable electronic device or a small household electrical appliance when it is dropped onto something. The dropped-off filler may fall in the housing and affect an electronic component disposed in the housing.

In view of this, it is an object of the present invention to provide a waterproof ventilation structure including a housing and a stretched porous PTFE membrane containing a filler and configured such that the filler dropped off from the membrane is less likely to fall in the housing. It is another object of the present invention to provide a waterproof ventilation member and a waterproof air-permeable membrane suitable for obtaining this waterproof ventilation structure.

The present invention provides a waterproof ventilation structure including: a housing having an interior space and an opening communicating the interior space with an exterior space; and a waterproof air-permeable membrane covering the opening. The waterproof air-permeable membrane is a layered product including a first stretched porous PTFE membrane containing a filler and a second stretched porous PTFE membrane not containing a filler, and the waterproof air-permeable membrane is disposed so that the second stretched porous PTFE membrane is located closer to the interior space than the first stretched porous PTFE membrane.

The present invention also provides a waterproof ventilation member including: a waterproof air-permeable membrane; and a fixing member bonded to a peripheral portion of the waterproof air-permeable membrane. The waterproof air-permeable membrane is a layered product including a first stretched porous PTFE membrane containing a filler and a second stretched porous PTFE membrane not containing a filler.

The present invention further provides a waterproof air-permeable membrane that is a layered product including: a first stretched porous PTFE membrane containing a filler; and a second stretched porous PTFE membrane not containing a filler.

According to the waterproof ventilation structure of the present invention, even if the filler is dropped off from the first stretched porous PTFE membrane containing the filler, the second stretched porous membrane not containing a filler catches the filler. Therefore, in this waterproof ventilation structure, the filler is less likely to fall in the housing. In addition, the waterproof ventilation member and the waterproof air-permeable membrane of the present invention can be used as components suitable for the production of the waterproof ventilation structure of the present invention.
FIG. 1 is a cross-sectional view showing an example of a waterproof ventilation structure according to the present invention.
FIG. 2 is a perspective view of a waterproof ventilation member used in the waterproof ventilation structure shown in FIG. 1.
FIG. 3 is a partially cut-away cross-sectional view showing another example of the waterproof ventilation structure according to the present invention.
FIG. 4 is an exploded perspective view of a waterproof ventilation member used in the waterproof ventilation structure shown in FIG. 3.

Hereinafter, embodiments of the present invention will be described with reference to the drawings.

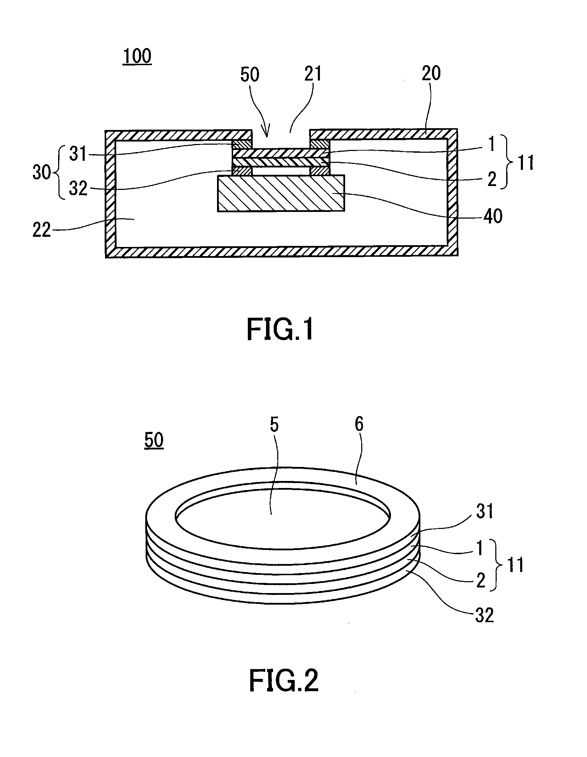

A waterproof ventilation structure 100 shown in FIG. 1 includes a housing 20 having an opening 21 and a waterproof air-permeable membrane 11 covering the opening 21. An interior space 22 and an exterior space of the housing 20 communicate with each other through the opening 21 covered by the waterproof air-permeable membrane 11, and a gas passing through the opening 21 enters the interior space 22 of the housing 20 or is discharged to the exterior space thereof through the waterproof air-permeable membrane 11.

The waterproof air-permeable membrane 11 is a layered product including a first stretched porous PTFE membrane 1 containing a filler and a second stretched porous PTFE membrane 2 not containing a filler. In the embodiment shown in FIG. 1, the stretched porous membranes 1 and 2 have the same surface size, but the second stretched porous PTFE membrane 2 may be larger than the first stretched porous PTFE membrane 1 so that the second stretched porous PTFE membrane 2 can cover the first stretched porous PTFE membrane 1 when viewed in a direction perpendicular to the membrane surface. A membrane other than the stretched porous membranes 1 and 2 may be added to the waterproof air-permeable membrane 11. The membrane which may be added is, for example, an additional stretched porous PTFE membrane (third stretched porous PTFE membrane). The third stretched porous PTFE membrane is added, for example, in order to further improve the water resistance. The water resistance of the waterproof air-permeable membrane 11 is preferably at least 30 kPa, and more preferably at least 50 kPa, in terms of a value measured in accordance with Japanese Industrial Standards (JIS) L 1092 high water pressure method.

Other examples of the membrane which may be added to the waterproof air-permeable membrane 11 are air-permeable support materials such as nonwoven fabric, woven fabric, and mesh. Such an air-permeable support material reinforces the waterproof air-permeable membrane to increase the mechanical strength of the membrane and thus improves the handling of the membrane. However, it is desirable to eliminate the air-permeable support material from the waterproof air-permeable membrane 11 depending on the type of an electronic component placed inside the housing in which the waterproof-air-permeable membrane 11 is to be disposed. In the case where the electronic component is an electroacoustic transducer such as a microphone, a speaker, and a buzzer, the mass per unit area of the waterproof air-permeable membrane 11 should not be too large. This is because the sound transmission characteristics of the waterproof air-permeable membrane 11 are influenced not only by the air permeation characteristics of the membrane but also by the vibration characteristics of the membrane. Therefore, in the case where an electroacoustic transducer is placed in the interior space of the housing and importance should be placed on the sound transmission of the waterproof air-permeable membrane 11, the waterproof air-permeable membrane 11 preferably consists of a two-layer membrane in which the first stretched porous PTFE membrane 1 and the second stretched porous PTFE membrane 2 are directly laminated together.

Double-sided adhesive tapes (hereinafter referred to as double-sided tapes) 31 and 32 serving as a fixing member 30 are bonded to the peripheral portion of the waterproof air-permeable membrane 11. The double-sided tape 31 is placed between the first stretched porous PTFE membrane 1 and the housing 20 so as to fix the waterproof air-permeable membrane 11 to the housing 20. The double-sided tape 32 is placed between the second stretched porous PTFE membrane 2 and the electronic component 40 so as to fix the waterproof air-permeable membrane 11 to the electronic component 40. The electronic component 40 suitable for use in the form of an integrated unit with the waterproof air-permeable membrane 11 and the housing 20 is, for example, the electroacoustic transducer mentioned above. However, the counterpart member to be bonded to the waterproof air-permeable membrane 11 via the second stretched porous PTFE membrane 2 is not limited to an electronic component. It may be an auxiliary member such as a gasket or a spacer placed between the electroacoustic transducer and the waterproof air-permeable membrane, a support member extending inwardly from the inner surface of the housing, or the like. In the embodiment shown in FIG. 1, the double-sided tapes 31 and 32 are disposed on both sides of the waterproof air-permeable membrane 11. However, if it is only necessary to fix the waterproof air-permeable membrane 11 only to the housing 20, only one of the double-sided tapes 31 and 32 may be used. In this case, unlike the embodiment shown in FIG. 1, the waterproof air-permeable membrane 11 may be fixed to the outer surface of the housing 20. In this embodiment, the double-sided tape 32 bonded to the peripheral portion of the second stretched porous PTFE membrane 2 is attached to the outer surface of the housing 20.

As shown in FIG. 2, in the waterproof air-permeable member 50, the double-sided tapes 31 and 32 cover the entire peripheral region 6 of the waterproof air-permeable membrane 11. In other words, the double-sided tapes 31 and 32 form a closed frame on the waterproof air-permeable membrane 11, and this closed frame surrounds an air-passage region 5 of the waterproof air-permeable membrane 11. In the embodiment shown in FIG. 2, the double-sided tapes 31 and 32 have the same surface size and are disposed on the peripheral region 6 of the waterproof air-permeable membrane 11 so that they coincide with each other when viewed in the direction perpendicular to the surface of the membrane 11. The double-sided tapes 31 and 32 each are formed of a base material layer and adhesive layers formed on both sides of the base material layer, but a single adhesive layer may be used as the fixing member 30. In the embodiment shown in FIG. 2, the double-sided tapes 31 and 32 have a ring shape. However, the shape of the double-sided tapes or the single adhesive layer is not limited to this, and it may be a rectangular frame shape, for example.

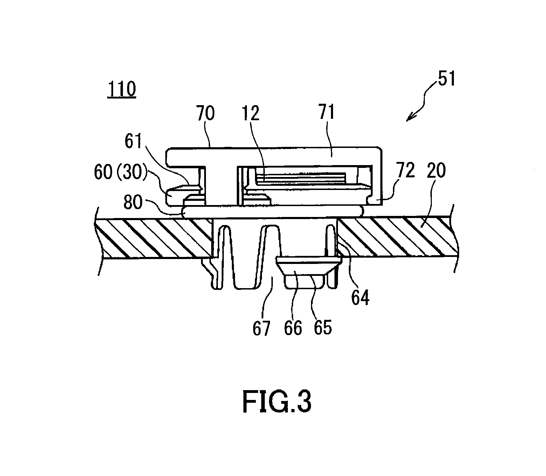

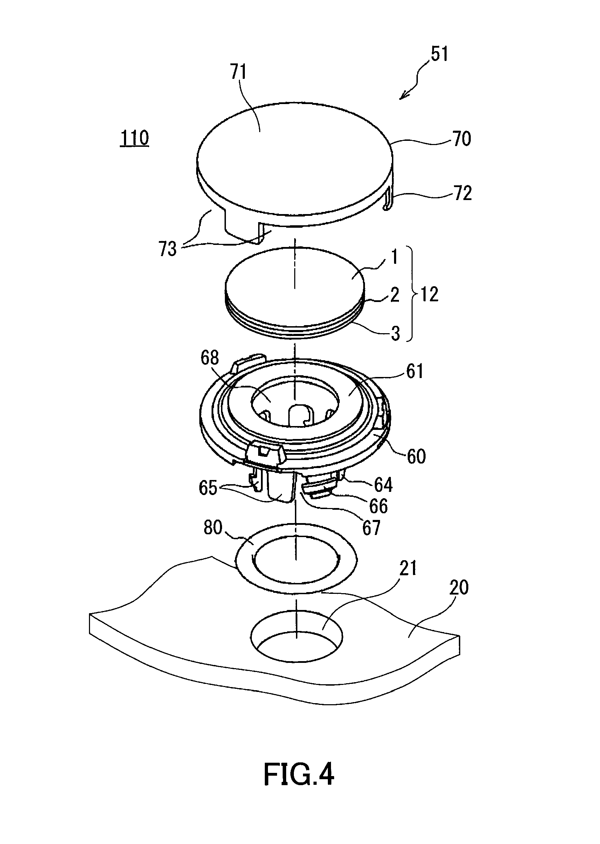

The waterproof ventilation member 50 including the waterproof air-permeable membrane 11 and the fixing member 30 is used to obtain the waterproof ventilation structure 100. The example of the fixing member 30 shown in FIG. 1 and FIG. 2 is the double-sided tapes 31 and 32, and another example of the fixing member 30 is a resin member having an air passage formed therein, as mentioned above. FIG. 3 and FIG. 4 show a waterproof ventilation structure 110 including an example of the waterproof ventilation member in which the resin member is used as the fixing member 30. A waterproof ventilation member 51 includes, as the fixing member 30, a support 60 having an air passage 68 formed therein. The support 60 includes a support portion 61 surrounding a part of the air passage 68 and supporting the entire peripheral region of a waterproof air-permeable membrane 12. The support 60 includes, in addition to the support portion 61, an insertion portion 64 to be inserted into the housing 20 through the opening 21 thereof. The insertion portion 64 is divided into a plurality of leg portions 65 by slits 67 extending in the insertion direction from the insertion start side. At least one of the leg portions 65 has a locking portion 66 formed on the outer peripheral surface thereof. The leg portion 65 having the locking portion 66 formed thereon is elastically deformed inwardly when it is pushed into the housing 20 through the opening 21, and is expanded outwardly and restored to its original shape after passing through the opening 21. The leg portion 66 expanding outwardly is engaged with the edge of the inner surface of the housing 20 adjacent to the opening 21, and thus prevents the support 60 from being detached from the opening 21.

The waterproof ventilation member 51 further includes a closed-end cover 70. The cover 70 includes a bottom portion 71 and a plurality of hooks 72 extending from the bottom portion 71 toward the waterproof air-permeable membrane 12. The hooks 72 are engaged with the lateral portion of the support 60 so as to fix the cover 70 and the support 60 together. When the cover 70 and the support 60 are fixed together, spaces 73 between the hooks 72 form a part of the air passage for ventilation of the interior space of the housing 20. In this state, the bottom portion 71 serves as a protective portion covering the entire surface of the waterproof air-permeable membrane 12 when viewed in the direction perpendicular to the surface of the waterproof air-permeable membrane 12. An O-ring 80 is interposed between the waterproof ventilation member 51 and the outer surface of the housing 20. The O-ring 80 securely fastens the hooks 72 to the outer surface of the housing 20 by its restoring force and prevents water or the like from entering the opening 21 through a gap between the waterproof ventilation member 51 and the outer surface of the housing 20. The use of the waterproof ventilation member 51 in which the waterproof air-permeable membrane 12 is previously bonded to the fixing member 30 (60) makes it possible to easily and securely fix the waterproof air-permeable membrane 12 to the housing 20, as in the case of the waterproof ventilation member 50.

The waterproof air-permeable membrane 12 is a layered product including the first stretched porous PTFE membrane 1 containing a filler, the second stretched porous PTFE membrane 2 not containing a filler, and an air-permeable support material 3 that are laminated together in this order. The air-permeable support material 3 is added to improve the strength and the handling. As the air-permeable support material 3, a non-filler containing nonwoven fabric, a woven fabric, a mesh, or the like is suitably used.

As the air-permeable support material 3, a material having a higher porosity than the stretched porous PTFE membranes is usually used. Therefore, in order to further reduce the possibility that the filler may fall, it is preferable that the first stretched porous PTFE membrane 1 and the second stretched porous PTFE membrane 2 be directly bonded together without the air-permeable support material 3 interposed therebetween. This can eliminate the possibility that the filler dropped off from the first stretched porous PTFE membrane 1 may fall outside the membrane 1 along the lateral surface of the air-permeable support material 3. Therefore, it is preferable that the waterproof air-permeable membranes 11 or 12 include a two-layer membrane in which the first stretched porous PTFE membrane 1 and the second stretched porous PTFE membrane 2 are directly laminated together, regardless of whether the electronic component 40 is an acoustic component or not.

The thicknesses of the stretched porous PTFE membranes 1 and 2 are not particularly limited. The thicknesses are as follows, for example. The thickness of the first stretched porous PTFE membrane 1 containing a filler is preferably 1 to 500 µm, and more preferably 5 to 300 µm. The thickness of the second stretched porous PTFE membrane 2 not containing a filler is preferably 1 to 500 µm, and more preferably 5 to 300 µm. The thickness of the layered product in which the first stretched porous PTFE membrane 1 and the second stretched porous PTFE membrane 2 are directly bonded together is preferably 2 to 1000 µm, and more preferably 10 to 600 µm.

The filler may be selected as appropriate depending on the intended use, and the type of the filler is not particularly limited. For example, the filler is a coloring filler and/or a conductive filler. When the filler is used for coloring, the use of a carbon-based black pigment such as carbon black or graphite is usually required in practice. However, the filler is not limited to this, and various types of colorants can be used depending on the color of the housing or the like. The use of a carbon-based conductive filler such as carbon black or graphite is also effective in imparting conductivity. Another example of the conductive filler is a metal powder.

The stretched porous PTFE membrane containing a filler can be obtained by premixing the filler into a PTFE sheet to be stretched. Specifically, when a PTFE fine powder and a liquid lubricant are mixed to obtain a PTFE molded product, the filler can be added to the mixture. Then, according to a procedure well known to those skilled in the art, the stretched porous PTFE membrane containing the filler can be obtained. As is well known, the stretched porous PTFE membrane is commonly produced by a process of making the membrane porous by so-called biaxial stretching.

Preferably, the two-layer membrane in which the first stretched porous PTFE membrane containing a filler and the second stretched porous PTFE membrane not containing a filler are directly bonded together is produced by a process including: stacking these stretched porous PTFE membranes, uniaxially-stretched PTFE membranes, or unstretched PTFE sheets; and sintering them integrally. PTFE is sintered by heating at a temperature equal to or higher than the melting point (327°C) of PTFE. Sintering for integration can also be performed while stretching the membranes.

Hereinafter, the present invention will be described in more detail by way of examples, but the present invention is not limited to the following examples.

### (Example)

20 parts by weight of liquid lubricant (normal decane) and 2 parts by weight of carbon black ("#4500" manufactured by Tokai Carbon Co., Ltd.) were added to 100 parts by weight of PTFE fine powder ("F104" manufactured by Daikin Industries, Ltd.) to prepare a pasty mixture. The mixture was formed into a round bar shape by paste extrusion, followed by rolling to obtain a PTFE sheet with a thickness of 0.2 mm. Next, the liquid lubricant was removed from the PTFE sheet in a drying furnace at 150°C. Furthermore, the PTFE sheet was stretched in its longitudinal direction at 280°C to 5 times its original length. Thus, a filler-containing uniaxially-stretched PTFE membrane was obtained. A non-filler-containing uniaxially-stretched PTFE membrane was obtained in the same manner as described above, except that no carbon black was added.

The filler-containing uniaxially-stretched PTFE membrane and the non-filler-containing uniaxially-stretched PTFE membrane were stacked and the stack was passed between a pair of rolls to pressure-laminate the membranes together. The laminated membrane was stretched in its transverse direction at 130°C to 10 times its original width, followed by sintering in a furnace at 360°C. Thus, a layered porous PTFE membrane product in which a stretched porous PTFE membrane containing a filler and a stretched porous PTFE membrane not containing a filler were directly laminated together was obtained. The thickness of the layered porous PTFE membrane product was 40 µm. The water entry pressure of the layered porous PTFE membrane product was 200 kPa when measured in accordance with JIS L 1092 high water pressure method.

The layered porous PTFE membrane product was punched into a circular shape with a diameter of 20 mm to obtain a waterproof air-permeable membrane. Next, one side of a ring-shaped double-sided tape ("No. 500" manufactured by Nitto Denko Corporation) was attached to a 5-mm wide peripheral portion (5-mm wide region along the outer edge) on the exposed surface of the stretched porous PTFE membrane not containing a filler. Thus, a waterproof ventilation member was obtained. Then, the other side of the double-sided tape was attached to a portion around a 10-mm diameter circular hole of a rectangular parallelepiped container from outside the container, so that the waterproof ventilation member was bonded to the container to cover the hole. This container was dropped from a height of 1 m, and then the interior of the container was observed. As a result, no carbon black was found in the container.

### (Comparative Example)

A stretched porous PTFE membrane containing a filler was obtained in the same manner as in Example, except that a step of stacking and laminating a filler-containing uniaxially-stretched PTFE membrane and a non-filler-containing uniaxially-stretched PTFE membrane obtained in the same manner as in Example is omitted. The thickness of this single-layer stretched porous PTFE membrane was 20 µm. The water entry pressure of the stretched porous PTFE membrane was 10 kPa when measured in accordance with JIS L 1092 high water pressure method. A carbon black falling test was performed in the same manner as in Example except that the single-layer stretched porous PTFE membrane thus obtained was used instead of the layered porous PTFE membrane product. As a result, separated carbon black was found in the container.

## Claims

1. A waterproof ventilation structure (100, 110) comprising:
a housing (20) having an interior space (22) and an opening (21) communicating the interior space with an exterior space; and
a waterproof air-permeable membrane (11, 12) covering the opening,
wherein
the waterproof air-permeable membrane is a layered product comprising a first stretched porous polytetrafluoroethylene membrane (1) containing a filler and a second stretched porous polytetrafluoroethylene membrane (2) not containing a filler, and
the waterproof air-permeable membrane (11, 12) is disposed so that the second stretched porous polytetrafluoroethylene membrane (2) is located closer to the interior space (22) than the first stretched porous polytetrafluoroethylene membrane (1).

2. The waterproof ventilation structure according to claim 1, wherein the layered product includes a two-layer membrane in which the first stretched porous polytetrafluoroethylene membrane (1) and the second stretched porous polytetrafluoroethylene membrane (2) are directly laminated together.

3. The waterproof ventilation structure according to claim 2, wherein the layered product consists of the two-layer membrane.

4. A waterproof ventilation member comprising:
a waterproof air-permeable membrane (11, 12); and
a fixing member (30, 60) bonded to a peripheral portion of the waterproof air-permeable membrane,
wherein the waterproof air-permeable membrane is a layered product comprising a first stretched porous polytetrafluoroethylene membrane (1) containing a filler and a second stretched porous polytetrafluoroethylene membrane (2) not containing a filler.

5. The waterproof ventilation member according to claim 4, wherein the layered product includes a two-layer membrane in which the first stretched porous polytetrafluoroethylene membrane (1) and the second stretched porous polytetrafluoroethylene membrane (2) are directly laminated together.

6. The waterproof ventilation member according to claim 5, wherein the layered product consists of the two-layer membrane.

7. A waterproof air-permeable membrane that is a layered product comprising:
a first stretched porous polytetrafluoroethylene membrane (1) containing a filler;
and a second stretched porous polytetrafluoroethylene membrane (2) not containing a filler.

8. The waterproof air-permeable membrane according to claim 7, wherein the layered product includes a two-layer membrane in which the first stretched porous polytetrafluoroethylene membrane (1) and the second stretched porous polytetrafluoroethylene membrane (2) are directly laminated together.

9. The waterproof air-permeable membrane according to claim 8, wherein the layered product consists of the two-layer membrane.
